# FASCICULE DE BREVET EUROPEEN

(11) **EP 3 008 979 B1**
(45) Date de publication et mention de la délivrance du brevet: **03.05.2017**
(21) Numéro de dépôt: 14728590.2
(22) Date de dépôt: 10.06.2014
(51) Int. Cl.: H05K 1/02, H05K 3/46

(54) **CIRCUIT IMPRIME A STRUCTURE MULTICOUCHE A FAIBLES PERTES DIELECTRIQUES ET REFROIDI**
GEKÜHLTE MEHRSCHICHTIGE LEITERPLATTE MIT NIEDRIGER DIELEKTRISCHER VERLUST
COOLED MULTILAYER PRINTED CIRCUIT BOARD WITH LOW DIELECTRIC LOSS

(30) Priorité: 12.06.2013 FR 1301342
(43) Date de publication de la demande: 20.04.2016
(73) Titulaire: Thales, 92400 Courbevoie (FR)
(72) Inventeur: BONNET, Sébastien, F-92400 Courbevoie (FR); VERDEYME, Serge, F-87060 Limoges Cedex (FR); CAMPOVECCHIO, Michel, F-87060 Limoges Cedex (FR); DRAVET, Alain, F-78690 St Remy l'Honore (FR); LIENHART, Marc-Yves, F-75015 Paris (FR)
(74) Mandataire: Henriot, Marie-Pierre
(86) Numéro de dépôt international: PCT/EP2014/061968
(87) Numéro de publication internationale: WO 2014/198688

(56) Documents cités:
- EP-A1- 0 197 148
- EP-A1- 1 639 870
- EP-A1- 1 643 552
- EP-A1- 1 901 406
- FR-A1- 2 960 377
- US-A- 5 459 639
- US-A1- 2005 180 111
- US-A1- 2006 133 043
- US-A1- 2007 297 155

## Description

L'invention concerne le domaine des cartes imprimées, et plus précisément un circuit imprimé de structure multicouche.

Les antennes de certains radars aéroportés réalisent un balayage électronique du faisceau dans un seul plan. Dans le plan où le faisceau est fixe, pour diminuer les coûts, on alimente des sous-réseaux de N éléments rayonnants avec une seule voie active, par l'intermédiaire d'un distributeur 1 :N, un distributeur étant constitué d'un ensemble de diviseurs reliés entre eux par des tronçons de ligne de transmission.

Pour réaliser le distributeur frontal entre la voie active et les N éléments rayonnants, il est connu d'utiliser une technologie de triplaque diélectrique, compatible du circuit imprimé multicouche qui contient également les composants actifs et les éléments rayonnants.

Le diélectrique utilisé est typiquement un substrat du commerce qui présente l'avantage d'une grande maturité technologique et d'un faible coût. Cependant il présente les inconvénients d'une faible conductivité thermique de 0.64W/(m.K) et des pertes diélectriques élevées, de l'ordre de 10 dB/m voire plus, qui dégradent les performances de l'antenne à l'émission (PIRE) et à la réception (G/T).

Il a été développé à la fin des années 1990, un procédé d'évacuation calorifique dans une structure de ligne à air dans un guide d'onde métallique. Ce procédé de refroidissement , consistant à insérer des plots en céramique entre la piste centrale de la ligne à air et la masse métallique du guide d'onde, à intervalles réguliers le long de la ligne, a été utilisé dans un distributeur gisement constitué d'anneaux hybrides, pour le démonstrateur d'antenne SAREX, acronyme de l'expression « radar SAR Expérimental en bande X». Cette structure présente l'inconvénient d'un volume et d'une masse relativement importants ; elle ne peut pas être intégrée dans un circuit imprimé multi-couches.

Un document US 5 459 639 A divulgue un circuit imprimé à strucrture multicouche.

En conséquence, il demeure à ce jour un besoin pour un circuit imprimé donnant simultanément satisfaction à l'ensemble des exigences précitées, en termes de minimisation de ses pertes diélectriques et de son échauffement.

Plus précisément l'invention a pour objet un circuit imprimé à structure multicouche. Il est principalement caractérisé en ce qu'il comprend :
- une première couche comportant un matériau diélectrique entre deux faces métallisées, usinée pour former un lamage traversant la couche sur toute son épaisseur,
- une deuxième couche comportant un matériau diélectrique entre deux faces métallisées et comportant une première cavité traversant la couche sur toute son épaisseur, assemblée à la première couche de manière à ce que cette première cavité soit en vis-à-vis du lamage,
- une troisième couche comportant un matériau diélectrique entre deux faces métallisées et comportant sur une face un composant électronique occupant une surface Scomp, l'autre face étant sans métal sur une section ≥ Scomp, cette troisième couche étant assemblée à la deuxième couche de manière à ce que le composant soit dans la première cavité,
- une quatrième couche comportant un matériau diélectrique entre deux faces métallisées et comportant une deuxième cavité, assemblée à la troisième couche de manière à ce que cette deuxième cavité soit en vis-à-vis de la première cavité,
- un élément de conduction thermique en deux parties :
   o l'une en métal dite capot thermique, insérée dans le lamage de la première couche de manière à fermer mécaniquement et électriquement la première cavité,
   o l'autre en matériau diélectrique à conduction thermique >30W/(m.K) , brasée à la première partie et placée dans la première cavité de manière à être en contact avec le composant électronique pour ainsi assurer une conduction thermique.

Un tel circuit imprimé permet de minimiser l'échauffement et les pertes diélectriques du composant électronique placé dans une cavité intégrée à une structure multicouche.

La deuxième cavité peut traverser la quatrième couche sur toute son épaisseur ; dans ce cas il comporte une cinquième couche à deux faces métallisées et assemblée à la quatrième couche.

Selon un mode de réalisation, la troisième couche comporte entre ses faces métallisées une première sous-couche de colle supportant le composant électronique et une deuxième sous-couche comportant une troisième cavité qui comporte éventuellement un ou plusieurs renforts.

Selon une caractéristique de l'invention, les sections des cavités sont égales.

Le capot thermique comporte avantageusement un lamage dans lequel est insérée la deuxième partie sous forme d'un plot thermique.

Le circuit comprend éventuellement un blindage par recouvrement des cavités par une couche de métallisation et/ou par des vias métallisés sur les côtés du circuit imprimé.

L'invention concerne aussi un procédé de fabrication d'un circuit imprimé tel que décrit, caractérisé en ce qu'il comporte :
a. des étapes de réalisation d'un sous-ensemble qui comprennent
   ∘ préparation de chaque couche,
   ∘ assemblage des couches,
   ∘ usinage de la première couche de manière à former le lamage,
b. une étape de réalisation de l'élément de conduction thermique par assemblage du plot thermique au capot,
c. une étape d'insertion de l'élément de conduction thermique dans le lamage de la première couche pour être en contact avec le composant électronique, après avoir ajouté :
   i. une colle thermiquement conductrice et électriquement isolante sur la face du plot destinée à être en contact avec ce composant,
   ii. une colle électriquement conductrice sur les faces du capot destinées à être en contact avec la première couche,
d. polymérisation de l'élément de conduction.

De manière avantageuse, au moins deux couches sont assemblées par thermodiffusion.

De préférence, l'étape b) comprend préalablement à l'assemblage du plot, un usinage du capot de manière à former une encoche destinée à recevoir en partie le plot.

Plus précisément, l'étape de préparation des couches comprend par exemple :
- Préparation des matériaux de la première couche,
- Préparation des matériaux de la deuxième couche et usinage de la première cavité,
- Préparation des matériaux de la troisième couche et placement du composant électronique,
- Préparation des matériaux de la quatrième couche et usinage de la deuxième cavité.

Cette étape de préparation des couches comprend éventuellement la préparation des matériaux de la cinquième couche.

L'étape de préparation de la troisième couche comprend généralement une étape de dépôt d'une couche de colle sur le matériau diélectrique, puis placement du composant sur la colle, puis usinage d'une troisième cavité sous le composant électronique destinée à être en vis-à-vis de la deuxième cavité.

Des renforts peuvent être disposés dans la troisième cavité.

D'autres caractéristiques et avantages de l'invention apparaîtront à la lecture de la description détaillée qui suit, faite à titre d'exemple non limitatif et en référence aux dessins annexés dans lesquels :
la figure 1 représente schématiquement un exemple de circuit imprimé selon l'invention,
la figure 2 représente schématiquement un exemple d'élément de conduction,
la figure 3 illustre schématiquement des étapes d'un exemple de procédé de fabrication d'un circuit imprimé selon l'invention.

D'une figure à l'autre, les mêmes éléments sont repérés par les mêmes références.

Dans la suite de la description, les expressions « haut », « bas », « dessus » (ou sur), « dessous » (ou sous), « supérieur », « inférieur » « avant », « arrière », « côté », etc, sont utilisées en référence à l'orientation des figures décrites. Dans la mesure où le dispositif peut être positionné selon d'autres orientations, la terminologie directionnelle est indiquée à titre d'illustration et n'est pas limitative.

Pour améliorer les performances d'émission et de réception de l'antenne, il est indispensable de minimiser l'échauffement des structures de transmission de puissance RF, ou plus généralement d'un composant électronique. Cet échauffement lié à la puissance dissipée dans cette structure est directement associé aux pertes frontales entre la voie active et les N éléments rayonnants, c'est-à-dire aux pertes du distributeur.

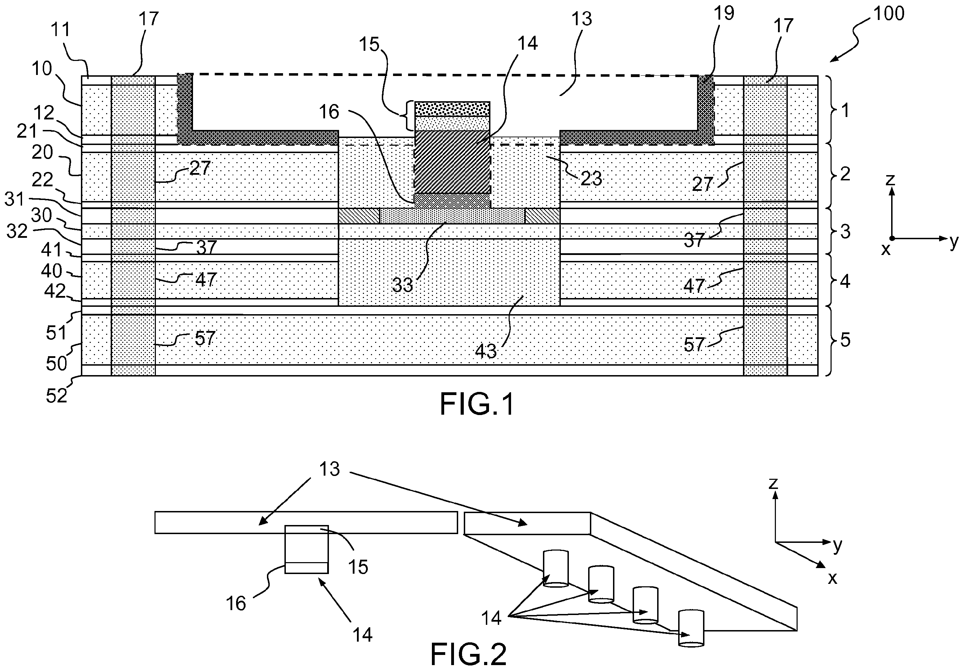

La figure 1 montre une section transversale d'un circuit imprimé 100 selon l'invention avec un composant électronique 33 sur un substrat diélectrique mince 30. Les couches inférieure 4 et supérieure 2 de ce substrat sont usinées pour former des cavités d'air 23 et 43, autour du composant électronique 33. Ces cavités d'air constituent un isolant thermique autour du composant électronique, mais freinent l'évacuation de chaleur lorsque celui-ci est soumis à de fortes puissances RF. Le composant électronique est donc refroidi par un élément 13,14 de conduction thermique >30W/(m.K), fixé sur ce composant électronique.

On va à présent décrire plus en détail cette structure.

Cet élément de conduction thermique comprend une partie supérieure métallique 13 (par exemple en cuivre ou argent ou diamant métallisé ou cuivre+pièces de diamant métallisé ou en un composite de type : argent-diamant, cuivre-diamant, aluminium-diamant, aluminium-silicium) désignée capot thermique auquel est fixé un plot thermique 14 (ou plusieurs) par exemple constitué de céramique. Tout type de céramique peut être utilisé, en particulier le nitrure d'aluminium (AIN), l'alumine (Al2O3), le nitrure de Bore (BN), l'oxyde de béryllium (BeO), le diamant (C), etc. Ces matériaux possèdent des conductivités thermiques de 33W/(m.K) (pour l'alumine) à 1800W/(m.K) (pour le diamant).

L'une des faces circulaires du plot 14 de céramique est brasée avec une brasure 15 sur le capot 13 de cuivre usiné. Ce capot qui ferme la cavité 23 sert de maintien sur la couche 2, et sert aussi de masse électrique au-dessus de la cavité d'air. L'autre face circulaire du plot 14 en céramique est collée sur le composant électronique 33, ce qui détermine son épaisseur ; il est collé au moyen d'une colle 16 électriquement isolante et thermiquement conductrice.

Ce plot généralement cylindrique a un diamètre compris entre 0.5mm et 0.7mm et une épaisseur comprise entre 400µm et 500µm. Le capot métallique en cuivre sur lequel est fixé le plot (ou les plots) en céramique possède une épaisseur comprise entre 400µm et 800µm.

Les dimensions du capot et des plots thermiques sont déterminées en fonction des épaisseurs des couches.

Pour effectuer un refroidissement constant sur l'ensemble du composant électronique, on peut avantageusement répartir plusieurs plots 14 périodiquement le long du capot 13 (comme montré figure 2) et donc du composant. On prend un pas de l'ordre de 20% de la longueur totale de la structure.

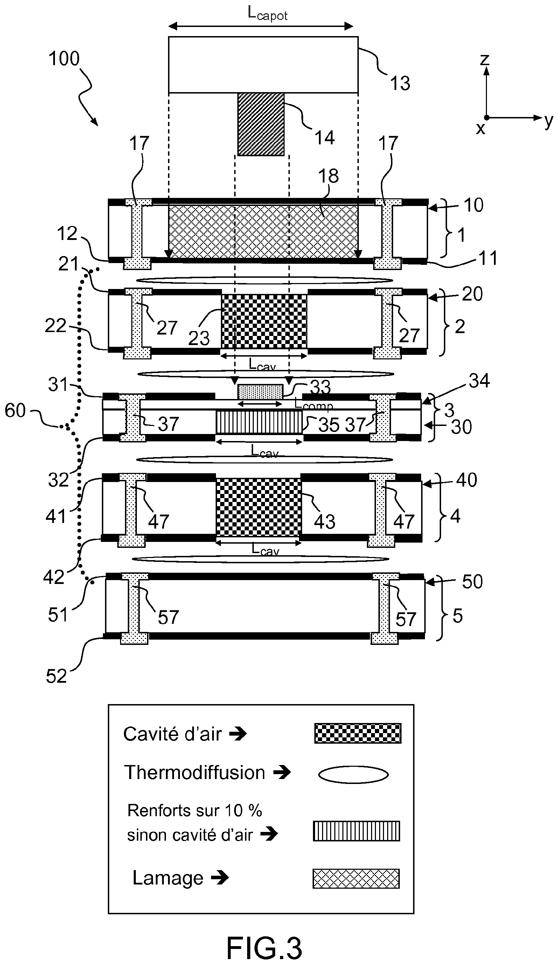

Une première couche supérieure 1 comportant un matériau diélectrique 10 (ne comportant généralement que ce matériau diélectrique) entre deux faces métallisées 11, 12, est usinée pour former un lamage 18 (montré figure 3) de section Scap (selon le plan des couches c'est-à-dire selon les axes X et Y) traversant la couche 1 sur toute son épaisseur (c'est-à-dire selon l'axe Z), dans lequel est inséré le capot thermique 13.

Une deuxième couche 2 comportant un matériau diélectrique 20 entre deux faces métallisées 21, 22, (et ne comportant que ce matériau diélectrique 20) comporte une première cavité 23 de section Scav traversant la couche 2 sur toute son épaisseur, et est assemblée à la première couche 1 de manière à ce que cette première cavité soit en vis-à-vis du lamage. Le ou les plots thermiques 14 sont dans cette cavité 23. Lorsque le composant électronique est une ligne de transmission, cette cavité forme un canal et l'élément de conduction comporte avantageusement plusieurs plots thermiques comme montré figure 2, qui sont fixés à la ligne.

Une troisième couche 3 comportant un matériau diélectrique 30 entre deux faces métallisées 31, 32, (et ne comportant que ce matériau diélectrique 30) comporte sur une face le composant électronique 33 placé en vis-à-vis de la première cavité 23 et qui occupe une surface Scomp ; l'autre face est sans métal sur une section ≥ Scomp, typiquement égale à Scav ; cette troisième couche est assemblée à la deuxième couche de manière à ce que le composant 33 soit dans la première cavité 23. Ce matériau diélectrique 30 qui forme le substrat du composant électronique, est un substrat organique du commerce, à faibles pertes, du même type que le matériau diélectrique dans lequel est formée la première cavité, mais avec une épaisseur plus faible.

Dans le cas d'une structure intégrant une ligne de propagation triplaque diélectrique à air, le composant électronique 33 est une piste centrale en cuivre, de section rectangulaire, qui est gravée sur le substrat de la couche 3. L'épaisseur typique de la piste centrale d'un triplaque diélectrique est comprise entre 30 µm et 50 µm. Pour réduire les pertes métalliques, on propose d'augmenter l'épaisseur de la piste, dans des limites raisonnables pour conserver les techniques de fabrication habituelles. Une piste dont l'épaisseur est comprise entre 50µm et 200µm, constitue un bon compromis : pertes - faisabilité. La largeur de la piste est optimisée pour obtenir l'impédance caractéristique souhaitée, en général 50 Ω.

Selon un premier mode de réalisation correspondant à la figure 3, le substrat sur lequel est gravé le composant électronique 33 est obtenu à partir d'un film de colle 34. L'épaisseur du film de colle est comprise entre 30 µm et 100 µm. Le film de colle repose sur un substrat organique mince 30, qui est évidé par usinage, au voisinage de la piste, pour réduire les pertes. Eventuellement des renforts sont disposés dans cet évidement 35, aussi désigné troisième cavité, pour renforcer le maintien mécanique du composant 33 sur le film de colle. L'ensemble "film de colle + substrat" est métallisé sur les deux faces 31, 32, avec une couche de cuivre et une finition Or (Au), compatible du processus d'assemblage.

Selon un deuxième mode de réalisation correspondant à la figure 1, le composant électronique 33 est directement gravé sur le substrat 30 de la couche 3.

Une quatrième couche 4 comportant un matériau diélectrique 40 entre deux faces métallisées 41, 42 (et ne comportant que ce matériau diélectrique 40) comporte une deuxième cavité 43 de même section Scav que la première cavité 23, et est assemblée à la troisième couche 3 de manière à ce que cette deuxième cavité soit en vis-à-vis de la première cavité.

De préférence, cette deuxième cavité 43 traverse cette couche 4 sur toute son épaisseur comme la première cavité et comme montré sur l'exemple de la figure 3. Dans ce cas, une cinquième couche 5 comportant un matériau diélectrique 50 entre deux faces métallisées 51, 52 est assemblée à la quatrième couche. Cette cinquième couche peut aussi être un multicouche comportant par exemple un empilement de plusieurs circuits élémentaires.

Ces cavités sont typiquement remplies d'air comme indiqué mais plus généralement elles peuvent être remplies d'un fluide de refroidissement.

On a :
Scap >Scav avec typiquement Scap > 1,5 x Scav
et Scav >Scomp.

Sur les figures, on a représenté les dimensions correspondantes selon l'axe Y : Lcap, Lcav et Lcomp.

Les faces des couches sont par exemple métallisées avec une couche de cuivre et une finition Etain (Sn) ou Or (Au) ou Argent (Ag), compatible d'un processus d'assemblage par thermodiffusion.

Dans l'exemple de la figure 1, les couches inférieures 4, 5 et supérieures 1, 2 ont une épaisseur comprise entre 200 µm et 500 µm. On peut choisir l'épaisseur de la couche 3, en fonction des applications.

Pour un circuit imprimé avec une piste centrale en cuivre gravée sur un substrat, l'introduction de l'élément de conduction thermique résulte en une diminution de la température maximale de 47°C pour un substrat d'environ 100 µm comme pour le 2è mode de réalisation, et de 40°C pour un substrat d'environ 50 µm comme pour le 1 er mode de réalisation.

En bande X de 8000 à 12000 MHz, les pertes linéiques de cette structure en triplaque à air sont typiquement de 5 à 6 dB/m, au lieu de 10 à 11 dB/m pour une structure en triplaque diélectrique plein avec des substrats organiques du commerce. Cela constitue un gain très significatif de bilan de puissance, surtout sur la structure frontale d'une antenne active.

Le composant électronique 33 peut être blindé électriquement, ce qui est avantageux lorsqu'il s'agit d'une ligne de propagation. Il est par exemple blindé sur les côtés par des trous métallisés 17, 27, 37, 47, 57 (encore appelés "vias") ou équivalents. Les trous métallisés ont par exemple un diamètre de 0.3 mm, imposé par la hauteur de l'empilage des couches. Les règles d'implantation imposent une distance minimale de 0.25 mm entre le bord des vias et la cavité d'air. Elles imposent aussi une distance minimale de 1.5 mm entre le bord des vias et le bord du circuit imprimé.

Les trous métallisés peuvent être remplacés par des murs métalliques continus, si la technologie de réalisation du circuit imprimé multicouche le permet.

Eventuellement, les parois de ces cavités peuvent être métallisées pour réaliser ce blindage.

On va à présent décrire un exemple de procédé de fabrication d'un circuit imprimé multicouche selon l'invention. Les couches peuvent être assemblées au moyen de films de colle. De préférence elles sont assemblées par thermodiffusion ; il s'agit d'un procédé d'assemblage des faces métallisées par pression mécanique et en température. Cela permet de conserver des épaisseurs constantes lors d'une fabrication collective, sans affaissement comme cela peut se produire avec un assemblage par collage des couches métallisées, et ainsi de garantir les mêmes propriétés électriques et thermiques d'un circuit à l'autre. Cette technique d'assemblage telle que décrite dans la demande de brevet EP1350418 présente l'avantage d'une réduction significative des coûts de fabrication du circuit imprimé multicouche, et d'une flexibilité de réalisation de connexions en Z entre différents circuits élémentaires, difficilement réalisables par les procédés classiques de fabrication des cartes imprimées ; en effet l'assemblage par thermodiffusion permet d'éviter les risques de fluage dû au film de colle utilisé dans les procédés classiques.

La technologie d'assemblage permet également de câbler des composants enterrés à l'intérieur du circuit imprimé multicouches, par exemple : des résistances ou des composants actifs.

Ce procédé permet d'assembler des couches métallisées, avec une finition différente, par exemple :
- Finition or pour une couche,
- Finition étain pour la couche qui lui fait face.

Pour réaliser un circuit imprimé tel que celui de l'exemple de la figure 1, on procède selon les étapes suivantes illustrées figure 3 :
- Etape n°1 de préparation de chaque couche 1, 2, 3, 4 et 5 : Usinage, lamage par exemple pour créer les cavités, voire pressage des sous-couches formant une couche comme pour le premier mode de réalisation de la couche 3.
- Etape n°2 de perçage des vias dans chaque couche.
- Etape n°3 de métallisation des vias et finition Or (Au) 3 µm pour chaque couche.
- Etape n°4 d'assemblage des couches entre elles avec pressage par thermodiffusion d'au moins deux couches. Dans l'exemple de la figure 3, toutes les couches sont assemblées par thermodiffusion : quatre interfaces sont thermodiffusées en un pressage, ce qui garantit une bonne reproductibilité des cavités lors d'une fabrication collective. On assemble ainsi cinq couches distinctes.
- Etape n°5 d'usinage de la première couche en vue d'y insérer l'élément de conduction 13, 14.

Ces étapes peuvent s'enchaîner dans l'ordre indiqué. Les étapes 2 et 3 peuvent éventuellement intervenir après l'étape d'assemblage.

Le sous-ensemble ainsi réalisé peut ensuite être intégré dans un circuit multicouche plus complexe, soit en ajoutant plus de couches dans l'empilage (on peut par exemple ajouter un multicouche sous la couche 5), soit en augmentant les dimensions dans les axes X et Y, soit en combinant les deux. Ce procédé permet de réaliser de manière industrielle des cavités intégrables facilement dans tout circuit multicouche hyperfréquence ou basse fréquence.

L'élément de conduction thermique est fabriqué puis assemblé à ce sous-ensemble.

Il est fabriqué en usinant le capot 13 de cuivre du diamètre du plot thermique 14 de façon à créer une encoche pour venir insérer une partie du plot en céramique. Ensuite on vient assembler le plot en céramique 14 sur le capot 13 en cuivre par brasure 15.

L'élément de conduction est ensuite inséré dans l'espace prévu à cet effet dans la première couche 1 du sous-ensemble précédemment assemblé comme montré figures 1 et 3 en :
o ajoutant une colle 16 électriquement isolante et thermiquement conductrice (montrée figure 1) en bout du plot thermique 14 de façon à le mettre en contact avec le composant électronique 33 à refroidir,
o ajoutant une colle 15 électriquement conductrice autour du capot en cuivre.

L'élément de conduction est alors polymérisé pour le rendre hermétique.

Ce procédé d'assemblage de plots en céramique sur un capot de cuivre n'est pas limitatif au niveau des composants des matériaux céramiques ni des dimensions des plots et du capot en cuivre.

On a décrit l'invention avec comme exemple un circuit imprimé à cavités pour réaliser des lignes à air faible perte, mais on peut également réaliser de la même manière tout type de cavité intégrable à un multicouche pour différents composants électroniques tels que des filtres suspendus, des composants actifs ou passifs tels que des résistances.

## Revendications

1. Circuit imprimé (100) à structure multicouche, **caractérisé en ce qu'**il comprend :
- une première couche (1) comportant un matériau diélectrique (10) entre deux faces métallisées (11, 12), usinée pour former un lamage (18) traversant la couche sur toute son épaisseur,
- une deuxième couche (2) comportant un matériau diélectrique (20) entre deux faces métallisées (21, 22) et comportant une première cavité (23) traversant la couche sur toute son épaisseur, assemblée à la première couche de manière à ce que cette première cavité soit en vis-à-vis du lamage,
- une troisième couche (3) comportant un matériau diélectrique (30) entre deux faces métallisées (31, 32) et comportant sur une face un composant électronique (33) occupant une surface Scomp, l'autre face étant sans métal sur une section ≥ Scomp, cette troisième couche étant assemblée à la deuxième couche de manière à ce que le composant soit dans la première cavité (23),
- une quatrième couche (4) comportant un matériau diélectrique (40) entre deux faces métallisées (41, 42) et comportant une deuxième cavité (43), assemblée à la troisième couche de manière à ce que cette deuxième cavité soit en vis-à-vis de la première cavité (23),
- un élément de conduction thermique en deux parties :
∘ l'une (13) en métal dite capot thermique, insérée dans le lamage (18) de la première couche (1) de manière à fermer mécaniquement et électriquement la première cavité (23),
∘ l'autre (14) en matériau diélectrique à conduction thermique >30W/(m.K), brasée à la première partie et placée dans la première cavité (23) de manière à être en contact avec le composant électronique (33) pour ainsi assurer une conduction thermique.

2. Circuit imprimé selon la revendication précédente, **caractérisé en ce que** la deuxième cavité (43) traverse la quatrième couche sur toute son épaisseur et **en ce qu'**il comporte une cinquième couche (5) à deux faces métallisées (51, 52) et assemblée à la quatrième couche.

3. Circuit imprimé selon l'une des revendications précédentes, **caractérisé en ce que** la troisième couche (3) comporte entre ses faces métallisées (31, 32) une première sous-couche de colle (34) supportant le composant électronique (33) et une deuxième sous-couche (30) comportant une troisième cavité (35).

4. Circuit imprimé selon la revendication précédente, **caractérisé en ce qu'**un ou plusieurs renforts sont disposés dans la troisième cavité (35).

5. Circuit imprimé selon l'une des revendications précédentes, **caractérisé en ce que** les sections des cavités sont égales.

6. Circuit imprimé selon l'une des revendications précédentes, **caractérisé en ce que** le capot thermique (13) comporte un lamage dans lequel est insérée la deuxième partie (14) sous forme d'un plot thermique.

7. Circuit imprimé selon l'une des revendications précédentes, **caractérisé en ce qu'**il comporte des vias métallisés (17, 27, 37, 47, 57) assurant l'interconnexion électrique des couches.

8. Circuit imprimé selon l'une des revendications précédentes, **caractérisé en ce que** le composant électronique (33) est une ligne de transmission ou un filtre ou une résistance.

9. Circuit imprimé selon l'une des revendications précédentes, **caractérisé en ce que** l'élément de conduction thermique comporte comme deuxième partie, plusieurs plots thermiques brasés au même capot thermique.

10. Circuit imprimé selon la revendication précédente, **caractérisé en ce que** le composant électronique est une ligne de transmission en contact avec les plots.

11. Circuit imprimé selon l'une des revendications précédentes, **caractérisé en ce qu'**il comprend un blindage par recouvrement des cavités par une couche de métallisation et/ou par des vias métallisés sur les côtés du circuit imprimé.

12. Procédé de fabrication d'un circuit imprimé (100) selon l'une des revendications précédentes, **caractérisé en ce qu'**il comporte :
a. des étapes de réalisation d'un sous-ensemble qui comprennent
∘ préparation de chaque couche (1, 2, 3, 4,5),
∘ assemblage des couches,
∘ usinage de la première couche (1) de manière à former le lamage (18),
b. une étape de réalisation de l'élément de conduction thermique par assemblage du plot thermique (14) au capot (13),
c. une étape d'insertion de l'élément de conduction thermique dans le lamage (18) de la première couche (1) pour être en contact avec le composant électronique (33), après avoir ajouté :
i. une colle (16) thermiquement conductrice et électriquement isolante sur la face du plot (14) destinée à être en contact avec le composant (33),
ii. une colle (15) électriquement conductrice sur les faces du capot (13) destinées à être en contact avec la première couche (1),
d. polymérisation de l'élément de conduction.

13. Procédé selon la revendication précédente, **caractérisé en ce qu'**au moins deux couches sont assemblées par thermodiffusion.

14. Procédé selon l'une des revendications 12 ou 13, **caractérisé en ce que** l'étape b) comprend préalablement à l'assemblage du plot, un usinage du capot de manière à former une encoche destinée à recevoir en partie le plot.

15. Procédé selon l'une des revendications 12 à 14, **caractérisé en ce que** l'étape de préparation des couches comprend :
- Préparation des matériaux de la première couche (1),
- Préparation des matériaux de la deuxième couche (2) et usinage de la première cavité (23),
- Préparation des matériaux de la troisième couche (3) et placement du composant électronique (33),
- Préparation des matériaux de la quatrième couche (4) et usinage de la deuxième cavité (43).

16. Procédé selon l'une des revendications 12 à 15 prise en combinaison avec la revendication 2, **caractérisé en ce que** l'étape de préparation des couches comprend la préparation des matériaux de la cinquième couche (5).

17. Procédé selon l'une des revendications 12 à 16, **caractérisé en ce que** l'étape de préparation de la troisième couche (3) comprend une étape de dépôt d'une couche de colle (34) sur le matériau diélectrique (30), puis placement du composant électronique (33) sur la colle (34), puis usinage d'une troisième cavité (35) sous la couche de colle destinée à être en vis-à-vis de la deuxième cavité (43).

18. Procédé selon la revendication précédente, **caractérisé en ce que** des renforts sont disposés dans la troisième cavité.

## Patentansprüche

1. Gedruckte Schaltung (100) mit mehrschichtiger Struktur, **dadurch gekennzeichnet, dass** sie Folgendes umfasst:
- eine erste Schicht (1), die ein dielektrisches Material (10) zwischen zwei metallisierten Flächen (11, 12) umfasst, bearbeitet zum Ausbilden einer Senkung (18), die die Schicht über ihre gesamte Dicke durchläuft,
- eine zweite Schicht (2), die ein dielektrisches Material (20) zwischen zwei metallisierten Flächen (21, 22) umfasst und einen ersten Hohlraum (23) umfasst, die durch die Schicht über ihre gesamte Dicke verläuft, mit der ersten Schicht auf eine solche Weise zusammengefügt, dass dieser erste Hohlraum der Senkung gegenüberliegt,
- eine dritte Schicht (3), die ein dielektrisches Material (30) zwischen zwei metallisierten Flächen (31, 32) umfasst und auf einer Fläche eine elektronische Komponente (33) umfasst, die eine Oberfläche Scomp einnimmt, wobei die andere Fläche auf einem Abschnitt ≥ Scomp metallfrei ist, wobei diese dritte Schicht so mit der zweiten Schicht zusammengefügt ist, dass sich die Komponente im ersten Hohlraum (23) befindet,
- eine vierte Schicht (4), die ein dielektrisches Material (40) zwischen zwei metallisierten Flächen (41, 42) umfasst und einen zweiten Hohlraum (43) umfasst, mit der dritten Schicht so zusammengefügt, dass dieser zweite Hohlraum dem ersten Hohlraum (23) gegenüberliegt,
- ein Wärmeleitelement aus zwei Teilen:
∘ einem (13) aus Metall, Thermohaube genannt, eingesetzt in die Senkung (18) der ersten Schicht (1), um den ersten Hohlraum (23) mechanisch und elektrisch zu schließen,
∘ dem anderem (14) aus dielektrischem Material mit einer Wärmeleitfähigkeit von > 30W/(m.K), gelötet auf den ersten Teil und so im ersten Hohlraum (23) platziert, dass er mit der elektronischen Komponente (33) in Kontakt ist, um eine Wärmeleitung zu gewährleisten.

2. Gedruckte Schaltung nach dem vorherigen Anspruch, **dadurch gekennzeichnet, dass** der zweite Hohlraum (43) die vierte Schicht über ihre gesamte Dicke durchläuft, und dadurch, dass sie eine fünfte Schicht (5) mit zwei metallisierten Flächen (51, 52) und mit der vierten Schicht zusammengefügt umfasst.

3. Gedruckte Schaltung nach einem der vorherigen Ansprüche, **dadurch gekennzeichnet, dass** die dritte Schicht (3) zwischen ihren metallisierten Flächen (31, 32) eine erste Klebstoffsubschicht (34), die die elektronische Komponente (33) trägt, und eine zweite Subschicht (30) umfasst, die einen dritten Hohlraum (35) aufweist.

4. Gedruckte Schaltung nach dem vorherigen Anspruch, **dadurch gekennzeichnet, dass** eine oder mehrere Verstärkungen in dem dritten Hohlraum (35) angeordnet sind.

5. Gedruckte Schaltung nach einem der vorherigen Ansprüche, **dadurch gekennzeichnet, dass** die Querschnitte der Hohlräume gleich sind.

6. Gedruckte Schaltung nach einem der vorherigen Ansprüche, **dadurch gekennzeichnet, dass** die Thermohaube (13) eine Senkung aufweist, in die der zweite Teil (14) in der Form einer thermischen Kontaktstelle eingeführt wird.

7. Gedruckte Schaltung nach einem der vorherigen Ansprüche, **dadurch gekennzeichnet, dass** sie metallisierte Durchkontaktierungen (17, 27, 37, 47, 57) umfasst, die die elektrische Verbindung der Schichten gewährleisten.

8. Gedruckte Schaltung nach einem der vorherigen Ansprüche, **dadurch gekennzeichnet, dass** die elektronische Komponente (33) eine Sendeleitung oder ein Filter oder ein Widerstand ist.

9. Gedruckte Schaltung nach einem der vorherigen Ansprüche, **dadurch gekennzeichnet, dass** das Wärmeleitelement als zweiten Teil mehrere thermische Kontaktstellen umfasst, die an dieselbe Thermohaube geschweißt sind.

10. Gedruckte Schaltung nach dem vorherigen Anspruch, **dadurch gekennzeichnet, dass** die elektronische Komponente eine Sendeleitung in Kontakt mit den Kontaktstellen ist.

11. Gedruckte Schaltung nach einem der vorherigen Ansprüche, **dadurch gekennzeichnet, dass** sie eine Abschirmung durch Abdecken der Hohlräume durch eine Metallisierungsschicht und/oder durch metallisierte Durchkontaktierungen auf den Seiten der gedruckten Schaltung umfasst.

12. Verfahren zur Herstellung einer gedruckten Schaltung (100) nach einem der vorherigen Ansprüche, **dadurch gekennzeichnet, dass** es Folgendes beinhaltet:
a. Schritte zum Realisieren einer Unterbaugruppe, die Folgendes beinhalten:
∘ Herstellen jeder Schicht (1, 2, 3, 4, 5),
∘ Zusammenfügen der Schichten,
∘ Bearbeiten der ersten Schicht (1), um die Senkung (18) zu bilden,
b. einen Schritt des Realisierens des Wärmeleitelements durch Zusammenfügen der thermischen Kontaktstelle (14) mit der Haube (13),
c. einen Schritt des Einführens des Wärmeleitelements in die Senkung (18) der ersten Schicht (1), damit es in Kontakt ist mit der elektronischen Komponente (33), nach dem Zugeben:
i. eines wärmeleitenden und elektrisch isolierenden Klebstoffs (16) auf die Fläche der Kontaktstelle (14), die mit der Komponente (33) in Kontakt gebracht werden soll,
ii. eines elektrisch leitenden Klebstoffs (15) auf die Flächen der Haube (13), die mit der ersten Schicht (1) in Kontakt kommen sollen,
d. Polymerisieren des Leitelements.

13. Verfahren nach dem vorherigen Anspruch, **dadurch gekennzeichnet, dass** wenigstens zwei Schichten durch Thermodiffusion zusammengefügt werden.

14. Verfahren nach Anspruch 12 oder 13, **dadurch gekennzeichnet, dass** der Schritt b) vor dem Zusammenfügen der Kontaktstelle ein Bearbeiten der Haube beinhaltet, um eine Kerbe zum teilweisen Aufnehmen der Kontaktstelle zu bilden.

15. Verfahren nach einem der Ansprüche 12 bis 14, **dadurch gekennzeichnet, dass** der Schritt des Herstellens der Schichten Folgendes beinhaltet:
- Herstellen der Materialien der ersten Schicht (1),
- Herstellen der Materialien der zweiten Schicht (2) und Bearbeiten des ersten Hohlraums (23),
- Herstellen der Materialien der dritten Schicht (3) und Platzieren der elektronischen Komponente (33),
- Herstellen der Materialien der vierten Schicht (4) und Bearbeiten des zweiten Hohlraums (43).

16. Verfahren nach einem der Ansprüche 12 bis 15 in Kombination mit Anspruch 2, **dadurch gekennzeichnet, dass** der Schritt des Herstellens der Schichten die Herstellung der Materialien der fünften Schicht (5) beinhaltet.

17. Verfahren nach einem der Ansprüche 12 bis 16, **dadurch gekennzeichnet, dass** der Schritt des Herstellens der dritten Schicht (3) einen Schritt des Absetzens einer Klebstoffschicht (34) auf das dielektrische Material (30), dann Platzieren der elektronischen Komponente (33) auf dem Klebstoff (34), dann Bearbeiten eines dritten Hohlraums (35) unter der Klebstoffschicht beinhaltet, bestimmt zum Platzieren gegenüber dem zweiten Hohlraum (43).

18. Verfahren nach dem vorherigen Anspruch, **dadurch gekennzeichnet, dass** Verstärkungen im dritten Hohlraum angeordnet sind.

## Claims

1. Printed circuit (100) with a multi-layer structure, **characterised in that** it comprises:
- a first layer (1) which comprises a dielectric material (10) between two metallised faces (11, 12) and which is processed so as to form a spotface (18) extending through the layer over the entirety of its thickness,
- a second layer (2) which comprises a dielectric material (20) between two metallised faces (21, 22) and which comprises a first cavity (23) extending through the layer over the entirety of its thickness and which is assembled on the first layer in such a manner that this first cavity is facing the spotface,
- a third layer (3) comprising a dielectric material (30) between two metallised faces (31, 32) and comprising, on one face, an electronic component (33) occupying a surface Scomp, the other face being without metal over a section ≥ Scomp, this third layer being assembled on the second layer in such a manner that the component is in the first cavity (23),
- a fourth layer (4) which comprises a dielectric material (40) between two metallised faces (41, 42) and which comprises a second cavity (43) and which is assembled on the third layer in such a manner that this second cavity is facing the first cavity (23),
- a heat-conducting element in two portions:
∘ one (13) which is produced from metal, called a thermal cover, and which is inserted into the spotface (18) of the first layer (1) so as to close, mechanically and electrically, the first cavity (23),
∘ the other (14) which is produced from a dielectric material with heat conduction > 30 W/(m.K), and which is brazed to the first portion and placed in the first cavity (23) so as to be in contact with the electronic component (33) so as to thereby ensure heat conduction.

2. Printed circuit according to the preceding claim, **characterised in that** the second cavity (43) extends through the fourth layer over the entirety of its thickness and **in that** it comprises a fifth layer (5) which has two metallised faces (51, 52) and which is assembled on the fourth layer.

3. Printed circuit according to either of the preceding claims, **characterised in that** the third layer (3) comprises, between its metallised faces (31, 32), a first underlayer of adhesive (34) supporting the electronic component (33) and a second underlayer (30) comprising a third cavity (35).

4. Printed circuit according to the preceding claim, **characterised in that** one or more reinforcements are arranged in the third cavity (35).

5. The printed circuit according to any one of the preceding claims, **characterised in that** the cross-sections of the cavities are equal.

6. Printed circuit according to any one of the preceding claims, **characterised in that** the thermal cover (13) comprises a spotface into which the second portion (14) is inserted in the form of a thermal pad.

7. Printed circuit according to any one of the preceding claims, **characterised in that** it comprises metallised VIAs (17, 27, 37, 47, 57) ensuring the electrical interconnection of the layers.

8. Printed circuit according to any one of the preceding claims, **characterised in that** the electronic component (33) is a transmission line or a filter or a resistor.

9. Printed circuit according to any one of the preceding claims, **characterised in that** the heat-conducting element comprises, as a second portion, a plurality of thermal pads brazed to the same thermal cover.

10. Printed circuit according to the preceding claim, **characterised in that** the electronic component is a transmission line in contact with the pads.

11. Printed circuit according to any one of the preceding claims, **characterised in that** it comprises shielding by covering the cavities by a layer of metallisation and/or by metallised VIAs on the sides of the printed circuit.

12. Method for manufacturing a printed circuit (100) according to any one of the preceding claims, **characterised in that** it comprises:
a. production steps for a sub-assembly which comprise:
∘ preparation of each layer (1, 2, 3, 4, 5),
∘ assembly of the layers,
∘ processing of the first layer (1) in order to form the spotface (18),
b. a production step for the heat-conducting element by assembling the thermal pad (14) on the cover (13),
c. a step of inserting the heat-conducting element into the spotface (18) of the first layer (1) so as to be in contact with the electronic component (33), after having added:
i. a heat-conducting and electrically insulating adhesive (16) on the face of the pad (14) which is intended to be in contact with the component (33),
ii. an electrically conductive adhesive (15) on the faces of the cover (13) which are intended to be in contact with the first layer (1),
d. polymerisation of the conducting element.

13. Method according to the preceding claim, **characterised in that** at least two layers are assembled by thermodiffusion.

14. Method according to either claim 12 or 13, **characterised in that** the step b) comprises, prior to the assembly of the pad, processing of the cover in order to form a notch which is intended to partially accommodate the pad.

15. Method according to any one of claims 12 to 14, **characterised in that** the step of the preparation of the layers comprises:
- preparation of the materials of the first layer (1),
- preparation of the materials of the second layer (2) and processing of the first cavity (23),
- preparation of the materials of the third layer (3) and placement of the electronic component (33),
- preparation of the materials of the fourth layer (4) and processing of the second cavity (43).

16. Method according to any one of claims 12 to 15, taken in combination with claim 2, **characterised in that** the step of the preparation of the layers comprises the preparation of the materials of the fifth layer (5).

17. Method according to any one of claims 12 to 16, **characterised in that** the step of the preparation of the third layer (3) comprises a step of the deposition of a layer of adhesive (34) on the dielectric material (30), then placement of the electronic component (33) on the adhesive (34), then processing of a third cavity (35) under the layer of adhesive intended to be facing the second cavity (43).

18. Method according to the preceding claim, **characterised in that** reinforcements are arranged in the third cavity.
